# EUROPÄISCHE PATENTANMELDUNG

(11) **EP 1 085 334 A2**
(43) Veröffentlichungstag der Anmeldung: **21.03.2001**
(21) Anmeldenummer: 00115252.9
(22) Anmeldetag: 13.07.2000
(51) Int. Cl.: G01R 31/3183, H03H 17/02

(54) **Prüfanordnung und Verfahren zum Testen eines digitalen elektronischen Filters**

(30) Priorität: 21.07.1999 DE 19934296
(71) Anmelder: Infineon Technologies AG, 81669 München (DE)
(72) Erfinder: Draxelmayr, Dieter, Dr., 9500 Villach (AT)
(74) Vertreter: Zimmermann & Partner

(57) **Zusammenfassung**

Die Erfindung betrifft einen Prüfanordnung für ein digitales elektronisches Filter

Es wird eine Prüfanordnung für ein digitales elektronisches Filter (13, 14) beschrieben, bei welchem der Ausgang des Filters auf den Eingang in der Weise rückgekoppelt ist, daß das digitale Ausgangssignal des Filters (13, 14) als Prüfsignal am Eingang anliegt. Das Filter (13, 14) wird mit einem Testsignal beaufschlagt und das Antwortsignal wird als nächstes Testsignal auf den Eingang rückgekoppelt.

## Beschreibung

Die Erfindung betrifft eine Prüfanordnung für ein digitales elektronisches Filter.

Mit zunehmender Komplexität von integrierten Digitalschaltungen wird es immer schwieriger, die Schaltungen mit vertretbarem Aufwand möglichst vollständig zu testen. Bekannt sind sogenannte Selbstprüfanordnungen, die als BIST (Build-In Self-Test) bezeichnet werden. Man kann damit nicht nur gute Testergebnisse erzielen, sondern es wird auch eine Möglichkeit geschaffen, wie man ohne Tester außerhalb der Produktion im Feld die Schaltung überprüfen kann. Dabei wird mit Hilfe einer Zusatzschaltung die zu testende Schaltung so angeregt, daß damit ein hoher Fehlerabdeckungsgrad erreicht wird. Da dieser Vorgang deterministisch ist, liegt also auch die Reaktion der zu testenden Schaltung von vorne herein fest und kann daher anhand von Vergleichswerten überprüft werden. Wenn die erwartete Reaktion auftritt, ist die Schaltung in Ordnung.

Es ist hierbei erforderlich, eine große Anzahl verschiedener Eingangssignale bereitzustellen, um die Voraussetzung zum Auffinden von möglichst vielen Fehlern zu schaffen. Das würde aber dazu führen, daß ein Prüfmustergenerator erforderlich ist, was naturgemäß mit unerwünschtem Aufwand verbunden ist.

In Patent Abstracts of Japan, E-212, 24. November 1983, Band 7, Nr. 264, JP 58-145217 A ist eine Prüfungsanordnung für ein digitales Filter gezeigt, bei der eine Selektionseinrichtung vorgesehen ist, um Daten während des Testbetriebs an eine Verarbeitungsschaltung weiter zu leiten. Das weiterverarbeitete Filterausgangssignal wird einer CPU zur Fehlerauswertung zugeführt. Von der CPU werden außerdem die Testdaten geliefert.

In der Literaturstehle Auer, Kimmelmann: "Schaltungstest mit Boundary-Scan", Heidelberg, Hüthig-Verlag, 1996, Seiten 6 bis 13 ist beschrieben, daß zum Testen Testmuster an Eingänge einer Schaltung angelegt werden, um die Reaktion der Schaltung zu prüfen. Dabei wird die erwartete Reaktion mit der tatsächlichen verglichen. Pseudozufällige Testmuster werden mittels rückgekoppelter Schieberegister erzeugt und dienen als Testmustergeneratoren.

In der US 5 754 455 ist ein digitales Filter mit bitserieller Architektur gezeigt. Die im Filter enthaltenen Flip-Flops werden zum Testen auf definierte Zustände rückgesetzt.

Der Erfindung liegt die **Aufgabe** zugrunde, eine Anordnung und ein Verfahren anzugeben, mit welchem eine große Anzahl von Prüfmustern erzeugt werden können und dennoch der dazu erforderliche Schaltungs- und Steueraufwand gering gehalten wird.

Diese Aufgabe wird anordnungsmäßig gelöst durch eine Prüfanordnung für ein digitales elektronisches Filter, mit einer an einen Ausgang des Filters angeschlossenen Auswerteschaltung, bei der ein Multiplexer vorgesehen ist, der zwischen einem Arbeitsbetrieb und einem Testbetrieb umschaltbar ist, und der Ausgang des Filters über den Multiplexer in einem Testbetrieb auf den Eingang in der Weise rückgekoppelt ist, daß das digitale Ausgangssignal des Filters als Prüfsignal am Eingang anliegt.

Verfahrensmäßig wird die Aufgabe gelöst durch ein Verfahren zum Testen eines digitalen Filters, bei dem ein Ausgangssignal des Filters in einem Testbetrieb mit einem Referenzsignal verglichen wird und bei dem das Filter im Testbetrieb mit einem Testsignal beaufschlagt wird, mindestens das Antwortsignal als nächstes Testsignal auf den Eingang rückgekoppelt wird und in einem Arbeitsbetrieb das Filter mit einem anderen Signal beaufschlagt wird.

Der Vorteil der Erfindung liegt darin, daß bereits mit einem sehr einfachen anfänglichen Eingangssignal eine relativ hohe Testabdeckung erreicht wird. Das Filter selbst erzeugt nämlich aus dem einfachen Eingangssignal eine komplexere Antwort, die man bei jedem Testdurchlauf mit an sich bekannten Sollwerten vergleichen kann, die auf einfache Weise mit errechneten Sollwerten verglichen werden können.

Die Erfindung ermöglicht es, mit sehr geringem Schaltungsaufwand Prüfmuster für eine deterministische Prüfung zu erzeugen und diese Prüfmuster noch dazu effizient zu gestalten, d.h. mit kurzer Laufzeit und hoher Fehlererkennung.

Eine bevorzugte Weiterbildung der Erfindung besteht darin, daß der Ausgang des Filters über eine serielle Leitung auf den Eingang zurückgeführt ist. Besonders gute und kostengünstige Weiterbildungen werden dadurch erreicht, daß eingangsseitig ein paralleles Dezimierungsfilter angeordnet ist, dem ein bitserielles Filter nachgeschaltet ist, dessen Ausgang auf den Eingang des Dezimierungsfilters rückgeführt ist.

Um einen schnellen und einfachen Wechsel vom Arbeitsbetrieb zum Testbetrieb vornehmen zu können, ist es zweckmäßig, daß ein Wechselschalter vorhanden ist, über welchen wahlweise entweder ein zu filterndes Signal oder das rückgeführte Signal an das Filter durchschaltbar ist.

Grundsätzlich können sehr gute Testergebnisse dadurch erzielt werden, daß als erstes Testsignal ein Einheitssprung angelegt wird, was auf einfach Weise durch Fixieren des Filtereingangs auf logisch-1 realisiert werden kann. Dieses ist nicht nur sehr einfach durchzuführen, sondern das Filter muß daraus die Sprungantwort errechnen, womit bereits eine relativ hohe Testabdeckung erreicht wird, wenn man die einzelnen errechneten Datenworte mit ihrem Sollwert vergleicht.

Eine besonders vorteilhafte Weiterbildung besteht darin, daß das rückgekoppelte Signal im Rückkopplungszweig verändert wird, wobei bevorzugt eine Verwürfelung vorgenommen wird. Es können damit noch mehr Fehler erkannt werden.

Es kann auch vorteilhaft sein, ein "weißes Rauschen" als Eingangssignal zu verwenden, zu dessen Erzeugung beispielsweise ein Pseudozufallsgenerator verwendet werden kann.

Ein dem "weißen Rauschen" gleichwertiges Signal erhält man vorzugsweise dadurch, daß das Ausgangssignal des Filters bitseriell als Eingangssignal an das Dezimierungsfilter gekoppelt wird. Die ständig und sehr unregelmäßig wechselnden Daten in einem bitseriellen Datenstrom haben die gleiche Wirkung wie die aus der Theorie bekannte "weiße Rauschquelle".

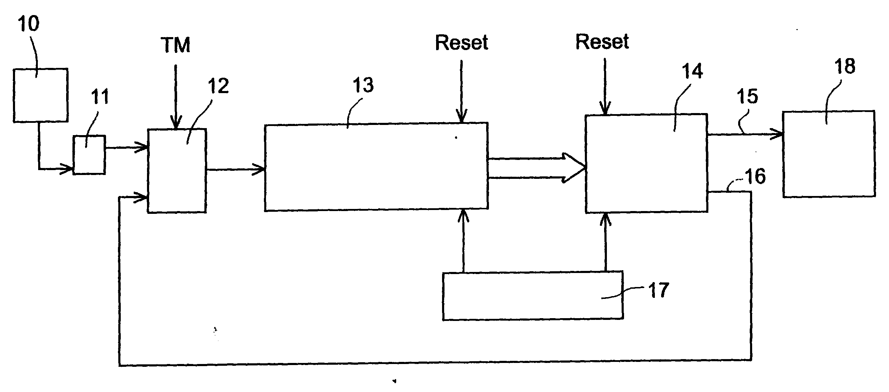

Nachfolgend wird die Erfindung anhand eines in der Zeichnung dargestellten Ausführungsbeispieles weiter erläutert.

Die einzige Figur zeigt schematisch ein Blockschaltbild einer Prüfanordnung für ein digitales elektronisches Filter.

Ein beispielsweise von einem Sensor 10, wie einem integrierten Drucksensor, kommendes Meßsignal wird über einen Analog/Digitalwandler 11 einem Multiplexer 12 zugeführt. Der Multiplexer 12 ist über ein Signal TM zwischen einem Arbeitsbetrieb und einem Testbetrieb umschaltbar.

Im Arbeitsbetrieb wird das Ausgangssignal des Analog/Digitalwandlers 11 über den Multiplexer 12 an ein Dezimierungsfilter 13 durchgeschaltet, welches den Bitstrom in parallele Datenworte geringerer Frequenz dezimiert. Dem Dezimierungsfilter 13 ist ein weiterer Filter 14 nachgeschaltet, typischerweise ein IIR. Um den Schaltungsaufwand niedrig zu halten, kann der weitere Filter 14 bitseriell ausgebildet sein. An einem Ausgang 15 liegt das Ausgangssignal der gesamten Filterschaltung an, d.h., hier kann die Reaktion auf ein Eingangssignal beobachtet und mit Referenzsignalen verglichen werden.

Das Ausgangssignal der Filterschaltung wird im Testbetrieb in einer Auswerteschaltung 18 geprüft. Die Referenzsignale sind hierbei zum Beispiel in einem Datenspeicher abgespeichert. Die Auswerteschaltung kann als separate Schaltung ausgeführt sein, die nur während des Testbetriebs am Ausgang 15 angeschlossen ist. Alternativ ist auch eine integrale Ausbildung mit der Filteranordnung möglich.

Über einen zweiten Ausgang wird über eine bitserielle Leitung 16 das bitserielle Ausgangssignal des weiteren Filters 14 über den Multiplexer 12 als Eingangssignal an das Dezimierungsfilter 13 angelegt. Wenn der Multiplexer 12 umgeschaltet wird, gelangen auf diese Weise unregelmäßig wechselnde Daten in das Dezimierungsfilter 13 und wirken dort wie "weißes Rauschen". Die beiden Filter 13, 14 werden über eine Ablaufsteuerung 17 angesteuert.

Anstelle des weiteren bitseriellen Filters 14 kann auch eine parallele Filterstruktur eingesetzt werden (nicht dargestellt). Das parallele Ausgangssignal kann dann zusätzlich noch verwürfelt werden, beispielsweise indem das kleinstwertige Bit auf das höchstwertige Bit gelegt wird. Das Prinzip der Rückkopplung der Ausgangsdaten auf den Filtereingang bleibt dabei erhalten.

Auch bei einer Ausführung mit einem bitseriellen weiteren Filter 14 können die bitseriellen Daten auf der Leitung 16 einer seriell/parallel-Umwandlung unterzogen und nach einer Verwürfelung wieder in einen seriellen Datenstrom rückgeführt werden.

Im Testbetrieb wird zunächst ein Reset der beiden Filter 13, 14 in einen definierten Zustand durchgeführt und gleichzeitig der Multiplexer 12 auf die bitserielle Leitung 16 umgeschlatet. Aufgrund des Resets liegt dann ausgangsseitig auf der Leitung 16 zunächst beispielsweise ein logisch-1-Signal an.

Es bewirkt ein Sprungantwort-Signal am Filterausgang 15, dessen Überprüfung in der Auswerteschaltung 18 gegebenenfalls bereits eine Vielzahl von Fehlern erkennen läßt. Das Sprungantwortsignal wird ferner als bitserieller Datenstrom über die Leitung 16 auf den Filtereingang zurückgeführt.

Man erhält dann auf der bit seriellen Leitung 16 einen Datenstrom mit häufigen Datenwechseln, welche das Ausgangssignal der Filteranordnung auf der Leitung 15 beeinflussen. Nach einer bestimmten Anzahl von Filterdurchläufen und Vergleich der Ergebnisse auf Leitung 15 mit Referenzwerten können eventuell weitere vorhandene Fehler der Filteranordnung bestimmt werden.

## Patentansprüche

1. Prüfanordnung für ein digitales elektronisches Filter (13, 14), mit einer an einen Ausgang (15) des Filters (13, 14) angeschlossenen Auswerteschaltung (18),
**dadurch gekennzeichnet,**
daß ein Multiplexer (12) vorgesehen ist, der zwischen einem Arbeitsbetrieb und einem Testbetrieb umschaltbar ist, und daß der Ausgang des Filters (13, 14) über den Multiplexer (12) in einem Testbetrieb auf den Eingang in der Weise rückgekoppelt ist, daß das digitale Ausgangssignal des Filters (13, 14) als Prüfsignal am Eingang anliegt.

2. Prüfanordnung nach Anspruch 1,
**dadurch gekennzeichnet,**
daß der Ausgang des Filters über eine serielle Leitung (16) auf den Eingang zurückgeführt ist.

3. Prüfanordnung nach Anspruch 1 oder 2,
**dadurch gekennzeichnet,**
daß eingangsseitig ein paralleles Dezimierungsfilter (13) angeordnet ist, dem ein bitserielles Filter (14) nachgeschaltet ist, dessen Ausgang auf den Eingang des Dezimierungsfilters (13) rückgeführt ist.

4. Prüfanordnung nach einem der vorhergehenden Ansprüche,
**dadurch gekennzeichnet,**
daß über den Multiplexer (12) im Arbeitsbetrieb ein zu filterndes Signal durchschaltbar ist.

5. Prüfanordnung nach einem der Ansprüche 1 bis 4,
**dadurch gekennzeichnet,**
daß eine Auswerteeinheit (18) gemeinsam mit dem Filter (13, 14) in einer Schaltung integriert ist.

6. Verfahren zum Testen eines digitalen Filters (13, 14), bei dem ein Ausgangssignal des Filters (13, 14) in einem Testbetrieb mit einem Referenzsignal verglichen wird,
**dadurch gekennzeichnet,**
daß das Filter (13, 14) im Testbetrieb mit einem Testsignal beaufschlagt wird, daß mindestens das Antwortsignal als nächstes Testsignal auf den Eingang rückgekoppelt wird und daß in einem Arbeitsbetrieb das Filter (13, 14) mit einem anderen Signal beaufschlagt wird.

7. Verfahren nach Anspruch 6,
**dadurch gekennzeichnet,**
daß die Rückkopplung eines Antwortsignals und dessen Verwendung als Testsignal wiederholt vorgenommen werden.

8. Verfahren nach Anspruch 6 oder 7,
**dadurch gekennzeichnet,**
daß das Antwortsignal seriell zurückgekoppelt wird.

9. Verfahren nach einem der Ansprüche 6 bis 8,
**dadurch gekennzeichnet,**
daß als erstes Testsignal ein Einheitssprung angelegt wird.

10. Verfahren nach einem der Ansprüche 6 bis 9,
**dadurch gekennzeichnet,**
daß das rückgekoppelte Signal im Rückkopplungszweig verändert wird.

11. Verfahren nach Anspruch 10,
**dadurch gekennzeichnet,**
daß das rückgekoppelte Signal verwürfelt wird.

12. Verfahren nach Anspruch 10,
**dadurch gekennzeichnet,**
daß das geringstwertige Bit des rückgekoppelten Signals auf das höchstwertige Bit gelegt wird.
